Europäisches Patentamt

European Patent Office

Office européen des brevets

(11) Publication number: **0 493 614 A1**

## EUROPEAN PATENT APPLICATION
### published in accordance with Art. 158(3) EPC

(21) Application number: **91913083.1**

(22) Date of filing: **19.07.91**

(86) International application number:
**PCT/JP91/00969**

(87) International publication number:
**WO 92/02045 (06.02.92 92/04)**

(51) Int. Cl.5: **H01L 27/115**

(30) Priority: **20.07.90 JP 192713/90**

(43) Date of publication of application:
**08.07.92 Bulletin 92/28**

(84) Designated Contracting States:
**DE FR GB IT NL**

(71) Applicant: **RAMTRON INTERNATIONAL CORPORATION**
**1850 Ramtron Drive**
**Colorado Springs Colorado 80918(US)**

(72) Inventor: **FUJISAWA, Akira, 3-5, Owa 3-chome**
**Suwa-shi**
**Nagano-ken 392(JP)**

(74) Representative: **Ouinterno, Giuseppe**
**c/o Jacobacci-Casetta & Perani S.p.A. Via Alfieri, 17**
**I-10121 Torino(IT)**

(54) **METHOD FOR MANUFACTURING SEMICONDUCTOR DEVICE.**

(57) The stress caused by the remarkable volumetric shrinkage of a thin film, which occurs on crystallization of the film, is minimized by patterning the thin film to be turned into a ferroelectric layer before the film is heat-treated. Consequently, since the influence on the characteristics of the transistor formed under a capacitive element is limited to a minimum and the ferroelectric thin film itself is not peeled too, a high quality semiconductor device formed with a capacitive element whose substrate is a ferroelectric layer can be manufactured at a high yield.

FIG. 3

## Technical Field

The present invention relates to a method of manufacturing a semiconductor memory element, more exactly to a method of manufacturing a non-volatile semiconductor device having an electrically polarizable ferroelectric layer as a basic material.

## Background Art

A memory device based on an electrically polarizable layer has been developed since the beginning of the 1950's.

Information could be stored by applying a voltage to upper and lower corresponding electrodes (corresponding to row and column address in case of an ordinary semiconductor memory device), thereby polarizing a cross point region of these electrodes. Moreover, the read-out process can be carried out by piezoelectrically or pyroelectrically activating a special memory region or by destructively reading out process. Furthermore, information can be kept permanently without supplying any outside power supply source by residual polarization having a ferroelectric. However, it has been turned out that a peripheral device,that is, an electronic controlling device necessary for writing in and reading out information, is comparatively complicated and a long access time is required. Therefore, at the end of the 1970's, there was proposed to directly integrate a ferromagnetic memory cell with a control module or to integrate the ferroelectric memory cell and the control module together. (R.C. Cook, US Patent 4,149,302 (1979)).

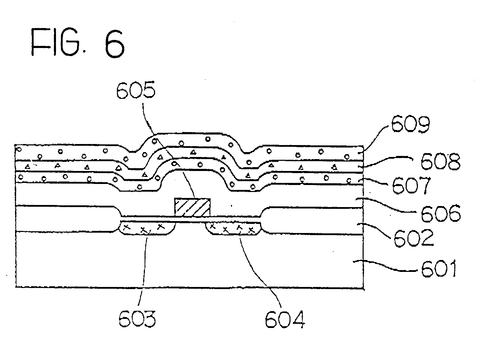

Recently, IEDM '87, pp. 850-851, proposes a memory device having a structure laminated in an MIS-type semiconductor device shown in Fig. 6. In Fig. 6, 601 is a P-type silicon substrate, 602 a LOGOS oxide film for separating elements, and 603 and 604 N-type diffusion layers to be a source and a drain, respectively. 605 is a gate electrode, and 606 is an interlayer insulating film. 608 is a ferroelectric film and constitutes a capacitor being sandwiched by a lower electrode 607 and an upper electrode 609.

In the conventional manufacturing method, the ferroelectric film 608 is either of $PbTiO_3$, PZT or PLZT and this is formed on the lower electrode shown by 607, by using a target having suitable lead component for over compensating the stoichiometrical composition through spattering method. 608 is non-crystalline form just after the formation of the thin film and it does not show ferroelectric nature. Accordingly, in order to form the objective capacitive element, it should be crystallized, for instance, by heat treatment at 600°C in an oxygen atmosphere. During this crystallization treatment, the thin film 608 shows volume shrinkage so that a stress is produced. This produced stress not only affects the characteristics of a transistor formed underneath the capacitive element but is may cause separation or exfoliation of the thin film itself when the stress exceeds the adhesive force of the thin film 608. Thus the manufacturing process thereafter may become difficult and may cause problem to be a source of affecting the yield of the manufactured devices.

The present invention has its object to solve such problems and to suppress the stress caused by the crystallization of the ferroelectric thin film in the minimum extent and to provide a method of manufacturing semiconductor devices formed with capacitive element based on high quality dielectric layer at high yield.

## Disclosure of the Invention

In the present invention, the method of manufacturing the semiconductor device formed with capacitive element based on ferroelectric layer is characterized to comprise;

a step of forming a thin film to be said ferroelectric layer on a semiconductor substrate,

a step of patterning said ferroelectric thin film to leave said film to be ferroelectric layer at least a region to form the capacitive element,

a step of applying heat treatment for the thin film to be the ferroelectric layer after applying said heat treatment.

The thin film to be the ferroelectric layer is applied the patterning step before applying the heat treatment so that the stress caused from a remarkable volume shrinkage of the thin film at the time of crystallization can be suppressed to minimum and thus the effect for the characteristics of the transistor formed underneath the capacitive element is also suppressed to minimum. While the exfoliation of the ferroelectric thin film itself is not occurred so that semiconductors formed with capacitive element having base material of high quality ferroelectric layer can be manufactured at high yield.

## Brief Description of the Drawings

Figs. 1-5 are essential cross sections of the manufacturing steps of a capacitive element of the semiconductor device having an electrically polarizable ferroelectric layer as a basic material according to the present invention,

Fig. 6 is an essential cross section of a semiconductor device having a conventional electrically polarizable ferroelectric film as the base material.

101    P-type silicon substrate

| 102 | interlayer insulating film |
| 103 | lower electrode |
| 201 | thin film to be a ferroelectric layer |
| 301 | crystallized ferroelectric thin film |
| 401 | upper electrode |
| 501 | P-type silicon substrate |
| 502 | interlayer insulation film |
| 503 | N-type diffusion layer |
| 504 | lower electrode |
| 505 | ferroelectric film |
| 506 | upper electrode |
| 507 | Aluminum wiring |

Best mode for practicing the Invention

Hereinafter, the invention will be explained in more detail by referring to the accompanying drawings and the practical embodiment.

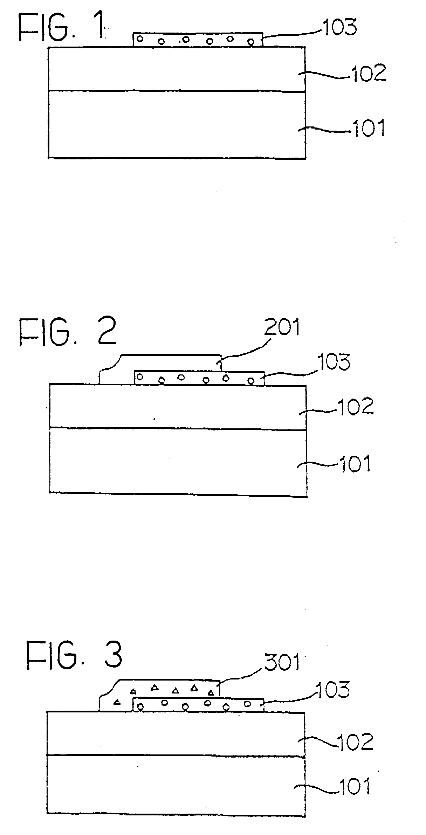

Figs. 1-5 are cross-sections showing essential steps for manufacturing a capacitive element of a semiconductor device shown in Fig. 6. This preferred embodiment will be explained for the sequential steps.

(a) At first, Platinum to be the lower electrode 103 is formed 1000 Å by spattering method over an interlayer insulation film (102) formed on a P-type silicon substrate (101) and a patterning is applied to leave the Platinum only for the region required for forming the capacitive element as shown in Fig. 1 by means of photolithography technique.

(b) Then a thin film 201 to be the ferroelectric layer according to the present invention is formed by spattering method and a patterning is applied as shown in Fig. 2 to leave the thin film to be the ferroelectric layer at least for the region required for forming the capacitive element.

(c) Thereafter, heat treatment is first applied for the thin film 201 to crystallize said thin film. This heat treatment is effected at 600°C in an oxygen atmosphere. As mentioned above, the thin film 201 to be the ferroelectric layer is applied the patterning so that the stress to cause a remarkable volume shrinkage of the thin film occurring at the time of crystallization can be suppressed to be the minimum extent. Accordingly, the effect for the characteristics of the transistor formed underneath the capacitive element is suppressed to the minimum extent and the separation or exfoliation of the ferroelectric thin film itself will not occur.

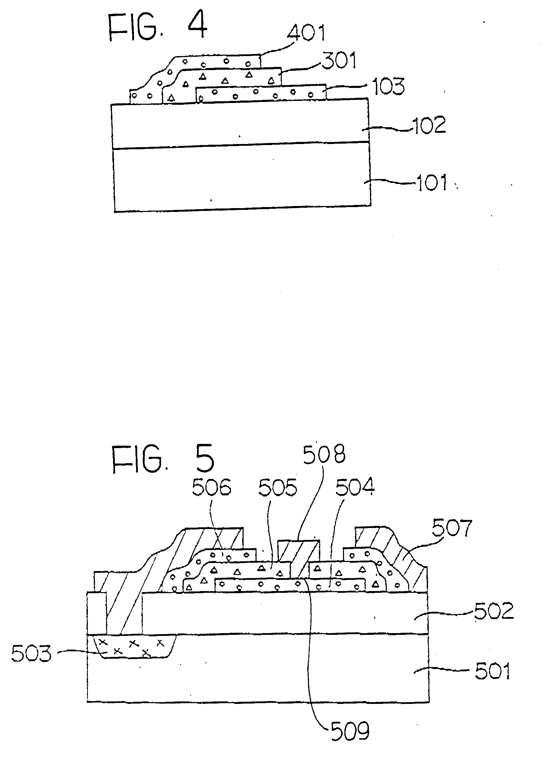

(c) Then, for instance Platinum to form the upper electrode 401 is applied for 1000 Å by spattering method and a patterning is effected by means of photolithograph technique as shown in Fig. 4 to leave Platinum only for the region required for forming the capacitive element.

(d) Thereafter, after providing connecting hole for providing connection between an electrode of the capacitive element and an element formed underneath the capacitive element, and Aluminum to be a connecting layer 507 is formed for 5000 Å and a necessary pattern is formed and eventually a construction shown in Fig. 5 is obtained. In this embodiment, as for the practical construction of the capacitive element, just one embodiment thereof is shown. However, it should be noticed that the invention is effective as far as the time sequence is satisfied in which the thin film to be the ferroelectric layer is first applied the heat treatment after the thin film to be the ferroelectric layer is applied the patterning.

Industrial Applicability

As has been mentioned in the above, according to the present invention, the thin film to be the ferroelectric layer is patterned before applying it the heat treatment, the stress caused by a remarkable volume shrinkage occurring at the crystallization is suppressed to minimum so that an affect to the characteristics of the transistor formed underneath the capacitive element is suppressed to minimum and the exfoliation of the ferroelectric thin film itself will not occur. Thus it becomes possible to manufacture a semiconductor device formed with a capacitive element having as the basic material of the ferroelectric layer at high yield and high quality.

**Claims**

1. A method of manufacturing a semiconductor device formed with a capacitive element having as its basic material a ferroelectric layer, comprising

a step of forming a thin film to be the ferroelectric layer on a semiconductor substrate,

a step of applying patterning for said ferroelectric thin film to leave the thin film to be ferroelectric layer at a region at least to form the capacitive element, and

a step of applying heat treatment for the thin film to be the ferroelectric layer only after the above patterning step.

FIG. 1

103

102

101

FIG. 2

201

103

102

101

FIG. 3

301

103

102

101

## FIG. 4

Labels: 401, 301, 103, 102, 101

## FIG. 5

Labels: 508, 506, 505, 504, 507, 502, 503, 501, 509

FIG. 6

# INTERNATIONAL SEARCH REPORT

International Application No  PCT/JP91/00969

## I. CLASSIFICATION OF SUBJECT MATTER (If several classification symbols apply, indicate all)

According to International Patent Classification (IPC) or to both National Classification and IPC

Int. Cl$^5$  H01L27/115

## II. FIELDS SEARCHED

### Minimum Documentation Searched

| Classification System | Classification Symbols |
|---|---|
| IPC | H01L27/115, 29/792 |

### Documentation Searched other than Minimum Documentation to the Extent that such Documents are Included in the Fields Searched

| | |
|---|---|
| Jitsuyo Shinan Koho | 1964 – 1990 |
| Kokai Jitsuyo Shinan Koho | 1973 – 1990 |

## III. DOCUMENTS CONSIDERED TO BE RELEVANT

| Category | Citation of Document, with indication, where appropriate, of the relevant passages | Relevant to Claim No. |
|---|---|---|
| P | JP, A, 3-34580 (Toshiba Corp.), February 14, 1991 (14. 02. 91) | 1 |
| E | JP, A, 3-19373 (Seiko Epson Corp.), January 28, 1991 (28. 01. 91) | 1 |
| X | JP, A, 2-183570 (Seiko Epson Corp.), July 18, 1990 (18. 07. 90), Lines 4 to 9, lower left column, page 2 | 1 |

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step
"Y" document of particular relevance; the claimed invention cannot be considered to involve an inventive step when the document is combined with one or more other such documents, such combination being obvious to a person skilled in the art
"&" document member of the same patent family

## IV. CERTIFICATION

| Date of the Actual Completion of the International Search | Date of Mailing of this International Search Report |
|---|---|
| October 14, 1991 (14. 10. 91) | October 21, 1991 (21. 10. 91) |
| International Searching Authority | Signature of Authorized Officer |
| Japanese Patent Office | |

Form PCT/ISA/210 (second sheet) (January 1985)